# EUROPEAN PATENT APPLICATION

(11) **EP 1 411 435 A2**
(43) Date of publication of application: **21.04.2004**
(21) Application number: 03022918.1
(22) Date of filing: 09.10.2003
(51) Int. Cl.: G06F 11/27

(54) **Command set for a software programmable verification tool having built-in selftest (bist) for testing and debugging an embedded device under test (dut)**

(30) Priority: 11.10.2002 US 269817
(71) Applicant: Broadcom Corporation, Irvine, California 92618-7013 (US)
(72) Inventor: Toros, Zeynep M., Irvine California 92618 (US); Terzioglu, Esin, Aliso Viejo California 92656 (US); Winograd, Gil I., Aliso Viejo California 92656 (US)
(74) Representative: Jehle, Volker Armin, Dipl.-Ing.

(57) **Abstract**

Aspects of the invention may include a software programmable verification tool for testing and debugging an embedded device under test by generating an instruction for causing at least one predetermined test to be executed by a BIST module on the embedded device under test. The generated instruction may be loaded into a parameterized shift register of the BIST module. An identity of at least one predetermined test may be determined based on the loaded instruction. At least one signal corresponding to the determined identity of the at least one predetermined test may be generated for causing control and execution of the testing and debugging of the device under test.

## Description

### BACKGROUND OF THE INVENTION

Certain embodiments of the invention relate to the testing of embedded devices. More specifically, certain embodiments relate to a command set for a software programmable verification tool having a built-in self-test (BIST) for testing and debugging an embedded device under test (DUT).

Advancement in chip technology has resulted in the development of embedded processors and controllers. Embedded processors and/or controllers may include microprocessor and/or microcontroller circuitry that have been integrated into single package containing associated companion logic and peripherals. Embedded processors differ from microprocessors and microcontrollers in that microprocessors and microcontrollers are typically coupled with associated logic on a circuit board to implement a specified application.

Further advancements in chip technology have increased packaging density to the point where it is now possible implement a standalone application on a single chip. In this regard, the resulting integrated circuit (IC) is called a system on a chip (SoC). A SoC may include one or more microprocessor and/or microcontroller elements, peripherals, associated logic and memory all fabricated on a densely packaged IC. For example, a SoC for a broadband set-top box may include a receiver, a transmitter, a digital signal processor, one or more encoders and decoders, random access memory (RAM), and non-volatile memory (NVM), all of which may be integrated on a single chip. The peripherals are typically called embedded peripherals. In the case of a memory element, the memory element may be called an embedded memory.

Notwithstanding, these advancements in chip technology are not without their challenges. Chip testing is a crucial to design, development, manufacture and integration phases. Chip density, has and in some cases, almost eliminated the use of traditional chip testing methods. For example, many embedded systems utilize multiple layers of epoxy having conduits and lines buried deep within, making them practically inaccessible to external debugging and verification tools. Additionally, traditional methods such as capturing traces using an oscilloscope may be problematic for many embedded processors that either operate at or have bus speeds in excess of a few hundred megahertz (MHz).

Although techniques such as boundary-scan have been developed to address some of these problems, boundary scan may not be a practical solution in embedded systems, for example embedded memories, where real estate is extremely expensive and in which embedded system components are densely packed. Boundary-scan typically includes embedding at least one test access port (TAP) and associated circuitry into an embedded system to facilitate tasks such as testing debugging, and verification. For example, the Institute of Electronic Engineers (IEEE) joint test action group (JTAG) TAP or IEEE 1149.1 standard utilizes boundary-scan for debugging and verifying embedded systems.

Furthermore, as the cost of memory continues to decline, increased packaging density technology has resulted a proliferation of embedded systems with large amounts of memory. Especially in cases where there is no direct connection between embedded memory module pins and the package pins, external testing may be extremely difficult if not impossible. Attempts to use complex and often convoluted test vectors are extremely time consuming and typically result in increased chip cost.

Further limitations and disadvantages of conventional and traditional approaches will become apparent to one of skill in the art, through comparison of such systems with some aspects of the present invention as set forth in the remainder of the present application with reference to the drawings.

### BRIEF SUMMARY OF THE INVENTION

Certain embodiments of the invention provide a software programmable verification tool for testing and debugging an embedded device under test. A method for testing and debugging an embedded device under test may include generating an instruction for causing at least one predetermined test to be executed by a BIST module on the embedded device under test. The generated instruction may be loaded into a parameterized shift register of the BIST module. An identity of at least one predetermined test may be determined based on the loaded instruction. At least one signal corresponding to the determined identity of the at least one predetermined test may be generated for causing control and execution of the testing and debugging of the device under test.

The generating step may further include the step of assembling at least one command into the generated instruction from within a host application software. The loading step may further include generating at least one clock signal from the host application software to control the loading of the instruction into the parameterized shift register. The loading step may further include the step of shifting the instruction into the parameterized shift register. The determining step may further include the step of identifying the command within the instruction, which was shifted into the parameterized shift register. The identifying step may further include the step of decoding the identified command.

The predetermined test may be any one or a combination of the following tests: reading the contents of a single memory location, writing to at least one memory location, writing to at least one memory location followed by a read of the written memory location, writing to a range of memory locations and reading from the written range of memory locations, writing a first data pattern to at least a portion of memory starting at a low memory address and ending at a high memory address followed by a read and consecutive write of a second data pattern starting from the low memory address to the high memory address, writing address information to a memory location followed by walking logic ones (1 s) and walking logic zeros (0s) pattern, executing a no operation command and executing sleep command.

Another embodiment of the invention may provide a system for programming a software verification tool for testing and debugging an embedded device under test. The system may include at least one generator adapted to generate an instruction for causing at least one predetermined test to be executed by a BIST module on the embedded device under test. At least one loader may be adapted to load the generated instruction into a parameterized shift register of the BIST module. An identifier may be adapted to determine an identity of the at least one predetermined test based on the loaded instruction. The at least one generator may be adapted to generate at least one signal corresponding to the determined identity of the at least one predetermined test for causing control and execution of the testing and debugging of the device under test.

The generator may further include an assembler adapted to assemble at least one command into the generated instruction within a host application software. The at least one generator may be adapted to generate at least one clock signal from the host application software, the at least one clock signal controlling the loading of the instruction into the parameterized shift register. The at least one loader may be adapted to include a shifter for shifting the instruction into the parameterized shift register. The identifier may be adapted to identify the command within the instruction shifted into the parameterized shift register. The identifier may be adapted to decode the identified command.

The tests may include any one or a combination of the following tests: reading the contents of a single memory location, writing to at least one memory location, writing to at least one memory location followed by a read of the written memory location, writing to a range of memory locations and reading from the written range of memory locations, writing a first data pattern to at least a portion of memory starting at a low memory address and ending at a high memory address followed by a read and consecutive write of a second data pattern starting from the low memory address to the high memory address, writing address information to a memory location followed by walking logic ones (1 s) and walking logic zeros (0s) pattern, executing a no operation command and executing sleep command.

Another embodiment of the invention may provide a command set for programming a software verification tool for testing and debugging an embedded device under test. The command set may include at least one instruction generated for causing at least one predetermined test to be executed by a BIST module on the embedded device under test. The at least one generated instruction may be parameterized and shifted into a parameterized shift register of the BIST module. The at least one instruction may include an identity of the at least one predetermined test based on the loaded instruction. The at least one instruction may be adapted to cause the generation of at least one signal corresponding to the identity of the at least one predetermined test for causing control and execution of the testing and debugging of the device under test.

The at least one instruction in the command set may include at least one command contained within a command portion of the at least one instruction. The command may be assembled into the command portion of the at least one instruction by a host application software. The command set may further include at least one counter contained within a counter portion of the at least one instruction and at least one counter increment contained within a counter increment portion of the at least one instruction. Additionally, the command set may further include at least one address contained within an address portion of the at least one instruction and at least one data contained within a data portion of the at least one instruction. The command set may also include at least mode select contained within a mode select portion of the at least one instruction. In this regard, the mode select may be a stop-on-error mode select. One or more commands in the command set may be adapted generate an output comprising at least one of a command, an error address, a RAM data output, an expected data, a column failure, a pass fail status, and at least one failure location.

According to an aspect of the invention, a method for programming a software verification tool for testing and debugging an embedded device under test is provided, the method comprising:
generating an instruction for causing at least one predetermined test to be executed by a BIST module on the embedded device under test;
loading said generated instruction into a parameterized shift register of said BIST module;
determining an identity of said at least one predetermined test based on said loaded instruction; and
generating at least one signal corresponding to said determined identity of said at least one predetermined test for causing control and execution of the testing and debugging of the device under test.

Advantageously, said generating further comprises assembling at least one command into said generated instruction within a host application software.

Advantageously, said loading further comprises generating at least one clock signal from said host application software, said at least one clock signal controlling said loading of said instruction into said parameterized shift register.

Advantageously, said loading further comprises shifting said instruction into said parameterized shift register.

Advantageously, said determining further comprises identifying said command within said instruction shifted into said parameterized shift register.

Advantageously, said identifying further comprises decoding said identified command.

Advantageously, said identity of said at least one predetermined test defines a test selected from the group consisting of, reading the contents of a single memory location, writing to at least one memory location, writing to at least one memory location followed by a read of said written memory location, writing to a range of memory locations and reading from said written range of memory locations, writing a first data pattern to at least a portion of memory starting at a low memory address and ending at a high memory address followed by a read and consecutive write of a second data pattern starting from said low memory address to said high memory address, writing address information to a memory location followed by walking logic ones (1 s) and walking logic zeros (0s) pattern, executing a no operation command and executing sleep command.

According to another aspect of the invention, a system for programming a software verification tool for testing and debugging an embedded device under test is provided, the system comprising:
at least one generator adapted to generate an instruction for causing at least one predetermined test to be executed by a BIST module on the embedded device under test;
at least one loader adapted to load said generated instruction into a parameterized shift register of said BIST module;
an identifier adapted to determining an identity of said at least one predetermined test based on said loaded instruction; and
said at least one generator adapted to generate at least one signal corresponding to said determined identity of said at least one predetermined test for causing control and execution of the testing and debugging of the device under test.

Advantageously, said at least one generator further comprises an assembler adapted to assemble at least one command into said generated instruction within a host application software.

Advantageously, said at least one generator is adapted to generate at least one clock signal from said host application software, said at least one clock signal controlling said loading of said instruction into said parameterized shift register.

Advantageously, said at least one loader further comprises a shifter adapted to shifting said instruction into said parameterized shift register.

Advantageously, said identifier is adapted to identify said command within said instruction shifted into said parameterized shift register.

Advantageously, said identifier further comprises a decoder adapted to decode said identified command.

Advantageously, said identity of said at least one predetermined test defines a test selected from the group consisting of, reading the contents of a single memory location, writing to at least one memory location, writing to at least one memory location followed by a read of said written memory location, writing to a range of memory locations and reading from said written range of memory locations, writing a first data pattern to at least a portion of memory starting at a low memory address and ending at a high memory address followed by a read and consecutive write of a second data pattern starting from said low memory address to said high memory address, writing address information to a memory location followed by walking logic ones (1s) and walking logic zeros (0s) pattern, executing a no operation command and executing sleep command.

According to another aspect of the invention, a command set for programming a software verification tool for testing and debugging an embedded device under test is provided, the command set comprising:
at least one instruction generated for causing at least one predetermined test to be executed by a BIST module on the embedded device under test;
said at least one generated instruction parameterized and shifted into a parameterized shift register of said BIST module;
said at least one instruction comprising an identity of said at least one predetermined test based on said loaded instruction; and
said at least one instruction for causing the generation of at least one signal corresponding to said identity of said at least one predetermined test for causing control and execution of the testing and debugging of the device under test.

Advantageously, said at least one instruction further comprises at least one command contained within a command portion of said at least one instruction said command assembled into said command portion by a host application software.

Advantageously,the command set further comprises:
at least one counter contained within a counter portion of said at least one instruction;
at least one counter increment contained within a counter increment portion of said at least one instruction;
at least one address contained within an address portion of said at least one instruction;
at least one data contained within a data portion of said at least one instruction; and
at least one mode select contained within a mode select portion of said at least one instruction.

Advantageously, said mode select is a stop-on-error mode select.

Advantageously, said mode select is a stop-on-error mode select.

Advantageously, said commands generate an output comprising at least one of a command, an error address, a RAM data output, an expected data, a column failure, a pass fail status, and at least one failure location.

According to another aspect of the invention, a machine-readable storage is provided, having stored thereon a computer program having at least one code section for implementing a command set for programming a software verification tool for testing and debugging an embedded device under test, the code sections executable by a machine for causing the machine to perform the steps comprising:
generating an instruction for causing at least one predetermined test to be executed by a BIST module on the embedded device under test;
loading said generated instruction into a parameterized shift register of said BIST module;
determining an identity of said at least one predetermined test based on said loaded instruction; and
generating at least one signal corresponding to said determined identity of said at least one predetermined test for causing control and execution of the testing and debugging of the device under test.

Advantageously, said generating code section further comprises at least one code section for assembling at least one command into said generated instruction within a host application software.

Advantageously, said loading code sections further comprise at least one code section for generating at least one clock signal from said host application software, said at least one clock signal controlling said loading of said instruction into said parameterized shift register.

Advantageously, said loading sections further comprise at least one code section for shifting said instruction into said parameterized shift register.

Advantageously, said determining code sections further comprise at least one code section for identifying said command within said instruction shifted into said parameterized shift register.

Advantageously, said identifying code sections further comprise at least one code section for decoding said identified command.

Advantageously, said code sections that determine the identity of said at least one predetermined test includes code sections that defines a test selected from the group consisting of, reading the contents of a single memory location, writing to at least one memory location, writing to at least one memory location followed by a read of said written memory location, writing to a range of memory locations and reading from said written range of memory locations, writing a first data pattern to at least a portion of memory starting at a low memory address and ending at a high memory address followed by a read and consecutive write of a second data pattern starting from said low memory address to said high memory address, writing address information to a memory location followed by walking logic ones (1s) and walking logic zeros (0s) pattern, executing a no operation command and executing sleep command.

These and other advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1a is a high-level block diagram of a software programmable verification tool in accordance with an embodiment of the invention.
FIG. 1b is a high-level block diagram illustrating the software programmable verification tool of FIG. 1 a located remotely from the embedded memory.
FIG. 1c is a high-level block diagram illustrating the software programmable verification tool of FIG. 1 co-located with the embedded memory.
FIG. 2 is a block diagram of an exemplary BIST module coupled to a memory in accordance with an embodiment of the invention.
FIG. 3 is a block diagram illustrating an exemplary parameterization for an input to the shift register of the BIST module of FIG. 2 in accordance with an embodiment of the invention.
FiG. 4 is an exemplary timing diagram that may be utilized to shift data in and out of the shift register of the BIST module of FIG. 2 in accordance with an embodiment of the invention.
FIG. 5 is a block diagram illustrating an exemplary parameterization for an input command for the shift register in accordance with an embodiment of the invention.
FIG. 6 is a block diagram illustrating an exemplary parameterization for output data for the shift register in accordance with an embodiment of the invention.
FIG. 7 is a flow chart illustrating an exemplary marching test using command 110 in accordance with an embodiment of the invention.
FIG. 8 is a flow chart illustrating an exemplary marching test using command 000 in accordance with an embodiment of the invention.

### DETAILED DESCRIPTION OF THE INVENTION

Aspects of the invention provide a command set for a software programmable verification tool having a built-in self-test (BIST) for testing and debugging an embedded device under test (DUT) such as an embedded memory. The invention provides a unique command set that may be used to test, for example, embedded single-port or dual-port embedded on-chip memories at any speed up to a maximum tolerated speed for the memory device. Advantageously, the command set for the software programmable BIST, may remove some design complexities from a device level to a software level. Software programmability also enables flexible test pattern generation during testing and consequently improves fault coverage of the BIST. Accordingly, since the command set for the software programmable BIST enables software programmability, it provides a flexible platform for system development and integration.

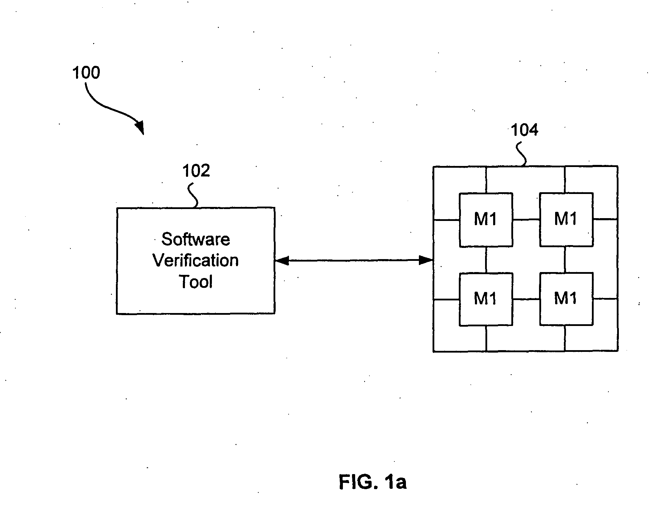

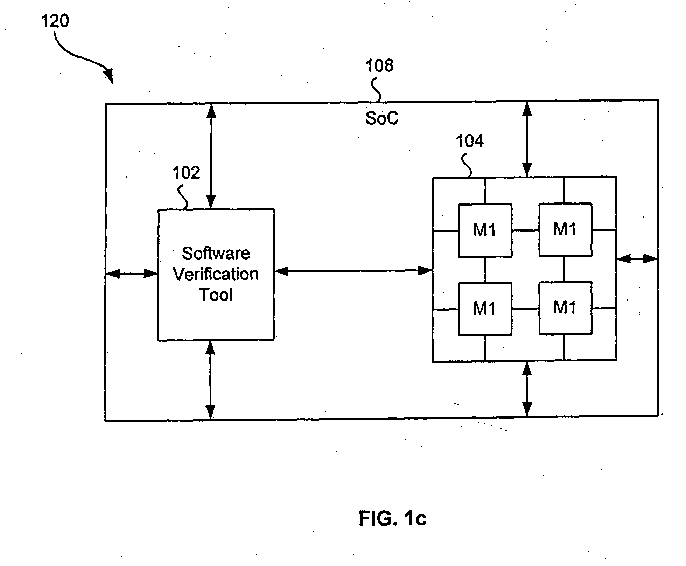

FIG. 1a is a high-level block diagram 100 of a software programmable verification tool in accordance with an embodiment of the invention. Referring to FIG. 1a, there is shown a software programmable verification tool 102 and an embedded memory 104. In one embodiment of the invention, the software programmable verification tool 102 may be remotely located from the embedded memory 104. In another embodiment of the invention, the software programmable verification tool 102 may be collated with the embedded memory 104 in a common embedded system such as a core.

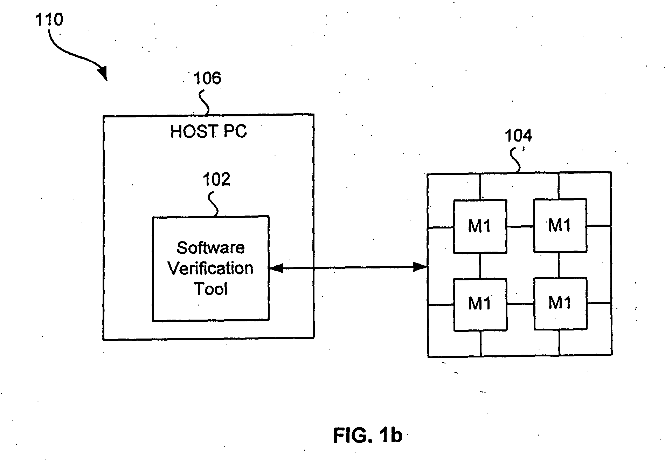

FIG. 1b is a high-level block diagram 110 illustrating the software programmable verification tool 102 of FIG. 1a located remotely from the embedded memory 104. Referring to FIG. 1b, the software programmable verification tool 102 may be part of a host system or a test fixture. For example, the host system may be a personal computer (PC) 106 or an embedded system tool (EST). In this regard, the host PC 106 may be configured as a host processor for the software programmable verification tool 102. The PC 106 may be coupled to the embedded memory 104 via, for example, a connector or socket adapted to communicate suitable signals, for example, clock, address, data and control signals, between the software programmable verification tool 102 and the embedded memory 102.

FIG. 1 c is a high-level block diagram 120 illustrating the software programmable verification tool 102 of FIG. 1 co-located with the embedded memory 104. Referring to FIG. 1a, the software programmable verification tool 102 may be part of an embedded system such as a SoC 108. In this regard, the software programmable verification tool may be arranged so that it is embedded within the fabric or core of the SoC 108. In this arrangement, the signals such as clock, address, data and control of the software programmable verification tool 102 may be coupled directly to the embedded memory 104 on chip. Various external pins on the SoC 108 may be adapted to provide certain signals off-chip.

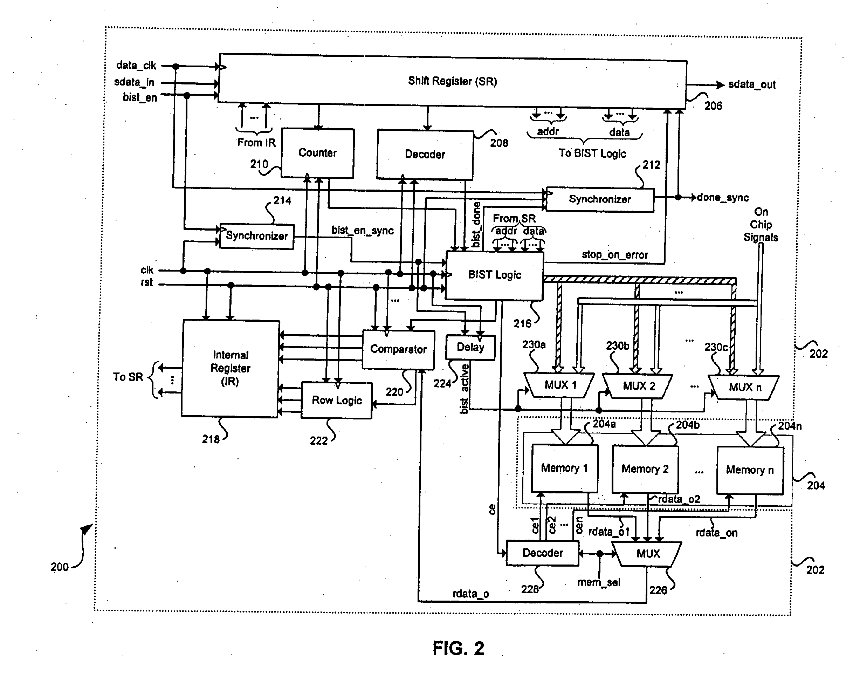

In accordance with an embodiment of the invention, the various embodiments of the software verification tool in FIG. 1 b and FIG. 1 c may include a built-in self-test (BIST) module. FIG. 2 is a block diagram of an exemplary BIST module 202 coupled to a memory 204 in accordance with an embodiment of the invention. The memory 204 may include various memories 204a, 204b, ..., 204n in accordance with an embodiment of the invention. Referring to FIG. 2, the BIST module 202 may include a shift register 206, a decoder 208, a counter 210, a first synchronizer 212, a second synchronizer 214, a BIST logic block 216, an internal register 218, a comparator 220, a row logic block 222, a delay block 224, first multiplexer (MUX) 226 and a plurality of multiplexers 230a, 230b, ..., 230n. The BIST module 202 may be adapted to test and debug, for example, custom single or dual port static memories at operational speed or at speeds lower than operational speed. Advantageously, the BIST module 202 may be adapted to test and debug multiple memories sequentially or in parallel. Sequential testing methodology may provide reduced on-chip area for fabrication, while parallel testing methodology may provide reduced test time.

The shift register 206 in BIST module 202 may be a sequential register that may be adapted to receive serially shifted test commands and/or data. Various portions of the shift register 206 may be coupled to counter 210, decoder 208 and the BIST logic block. An input signal (sdata_in) containing an instruction having a test command and/or associated data may be serially shifted into the shift register 206. An output signal (sdata_out) may be provided to shift data out of the shift register 206. A BIST enable signal (bist_en) and a data clock signal (data_clk) may control certain operations of the shift register 206, for example the shifting of data into and out of the shift register 206.

The decoder 208 may be coupled to the shift register 206. Accordingly, the decoder 208 may be configured to receive at least a portion of the (sdata_in) signal and decode at least a portion of the received (sdata_in) signal that may be serially shifted into the shift register 206. The portion of the serial data that the decoder 208 may receive may contain at least one command or instruction to be executed by the BIST module 202.

The BIST logic block 206 may be coupled to at least the decoder 208 and the counter 210. Additional inputs to the BIST logic block 206 may include, but are not limited to a system clock signal (clk) and a reset signal (rst). The system clock signal (clk) may be provided by a host system application and may be adapted to control various functions of the BIST module 202. The reset signal (rst) may also be provided from the host system application and may be adapted to reset various components of the BIST module 202 to a known state. The BIST logic block 206 may contain suitable circuitry and logic that may be configured to generate signals such as data, address, control, and timing signals. For example, BIST logic block 216 may be configured to generate a done signal, which may serve as an input to the first synchronizer 212. The BIST logic block 216 may also be configured to produce an output signal that may be provided as an input to the comparator 220.

The counter 210 may be coupled to the shift register 206 and may be adapted to monitor the commands being shifted into the shift register 206. In this regard, the counter 210 may count the number of consecutive executions of a command during a single test period. An output signal generated by the counter 210 may be provided as an input to the BIST logic block 210. Additional inputs to the counter 210 may include, but are not limited to, a system clock signal (clk) and a reset signal (rst). The system lock signal (clk) and the reset signal (rst) may be provided by the host system application and may be adapted to reset the counter 210 to a known state.

The first synchronizer 212 may be configured to synchronize the bist_done signal (bist_done) from the system clock to the data clock signal (data_clk). The data clock signal (data_clk) may be adapted as an input to the shift register 206 and the bist_done signal may be generated by the BIST logic block 210. The BIST logic block 210 may be configured to generate the bist_done signal, for example, at the end of completion of a specified test and/or operation. The synchronized output signal generated by the synchronizer 212 may include a done_sync signal. In one embodiment of the invention, upon synchronization of the done_sync signal, whenever the done_synch is set to logic one (1) or goes high, the shift register 206 may be overwritten with at least a portion of the contents of the internal register 218. In this regard, data results for any test may be loaded from the internal register 218 into the shift register 206. The result data may subsequently be shifted out of the shift register 206 whenever the bist_en signal is set to a logic zero (0) or pulled low.

The second synchronizer 214 may be configured to synchronize the system clock signal clk and the bist_en signal which may be an input to the shift register 206. A resulting synchronized signal bist_en_sycn may be provided as an input to the BIST logic block 216. The delay block 224 may be configured to introduce a delay in the bist_en_sync signal, thereby generating a bist_active signal. The bist_active signal may be coupled as an input select to the MUXes 230a, 230b, ... , 230n.

At least a portion of the I/O pins of the shift register may be coupled to the BIST logic block 216. For example, portions of the shift register 206 that may correspond to one or more addresses and/or one or more data may be coupled to corresponding address and data inputs of the BIST logic block 216. To support the stop on error mode of operation, a stop-on-error signal may be coupled to the BIST logic block 216. The BIST logic block 216 may be adapted to generate various data and control signals, some of which may be coupled to the MUXes 230a, 230b, ..., 230n as data input and/or select signals. Exemplary control signals generated by the BIST logic block 216 may include, but are not limited to, address, data, write enable (we), chip enable (ce), bist (bi) and sub-word writeable (sw) signals. In one aspect of the invention, the BIST module 202 may be configured so that the write enable (we), chip enable (ce), and software enable (sw) signals are active low signals, although the invention is not limited in the regard. One or more of the signals generated by the BIST logic block 216 may control operations, such as, enabling one or more of the MUXes 230a, 230b, ..., 230n to select one or more memory modules to be tested, which may include writing to and reading from the memory modules.

Decoder 228 and MUX 226 may be adapted to control the reading and writing of data to and from any one or more of the memory modules 204a, 204b, ..., 204n. A memory select signal mem_sel may be coupled to the decoder 228 and MUX 226 to enable the contents of an appropriate memory 204a, 204b, ... , 204n to be loaded into the comparator 220. The chip enable bit from the BIST logic block 216 may be provided as an input to the decoder 228 in order to select an appropriate one of the memory modules in memory 204 to be tested.

The comparator 220 may be coupled to the BIST logic block 216 via an expected data signal (expected_data). Comparator 220 may also be coupled to an output of MUX 226 to receive the RAM data output signal (rdata_o) from MUX 226. The comparator 220 may be adapted to include suitable circuitry and/or logic that may compare the expected data signal (expected_data) received from the BIST logic block 216 with corresponding RAM output data signal (rdata_o) signal from MUX 226. In this regard, the actual test result data or RAM data output rdata_o1, rdata_o2, ..., rdata_on read from memory modules 204a, 204b, ..., 204n respectively, may be selected by MUX 226 using a chip enable signal (ce) coupled to decoder 228 and a memory select signal (mem_sel) coupled to the MUX 226 and supplied to the comparator 220.

The comparator 220 may generate various output signals that may indicate a status and/or information pertaining to a test. For example, the comparator 220 may generate a RAM data out (rdata_o) signal to indicate the actual data read from a location in memory, an expected data signal (expected_data) which may indicate the data that was written to the memory, and an error_address signal indicating an address of a location in memory where an error occurred. The rdata_o signal, the expected_data signal and the error_address signals may be communicated to the internal register 218 where they may set one or more bits in specified memory locations and/or registers.

A row logic block 222 may be adapted to execute various row-redundancy algorithms based on data received from the comparator 220. An output error signal from comparator 220 may be coupled to an input of a row logic block 222. In one embodiment of the invention, the row logic block 222 may be adapted to generate oneo or more of a failing address location n signal (fail_loc_n), a failing column signal (fail_col), and a pass/fail signal (pass_fail). The fail_loc_n signal, the fail_col signal and the pass_fail signals may be communicated to the internal register 218 where they may set one or more bits in specified memory locations and/or registers.

In another aspect of the invention, the comparator 220 may be adapted to generate a col_fail signal that may be utilized to indicate the results of testing various columns of the memory module under test. In this regard, the comparator 220 may be configured to generate a rdata_o signal and an expected_data signal. The rdata_o signal may represent results read from one or more memory locations and the expected_data signal may represent corresponding results that were expected from the one or more memory location that were tested. The rdata_o and the expected_data signals and be adapted to set one or more corresponding rdata_o and/or expected_data bits in the internal register 218. Accordingly, one or more bits representing each of the rdata_o bits and the expected data bits may be accumulated and an XOR operation executed on a the accumulated rdata_o and expected_data bits. The col_fail signal may represent the cumulative results of the XOR operation on a column-by-column basis for the accumulated rdata_o and expected_data bits. Logic one (1) at the end of testing a column may represent a column failure.

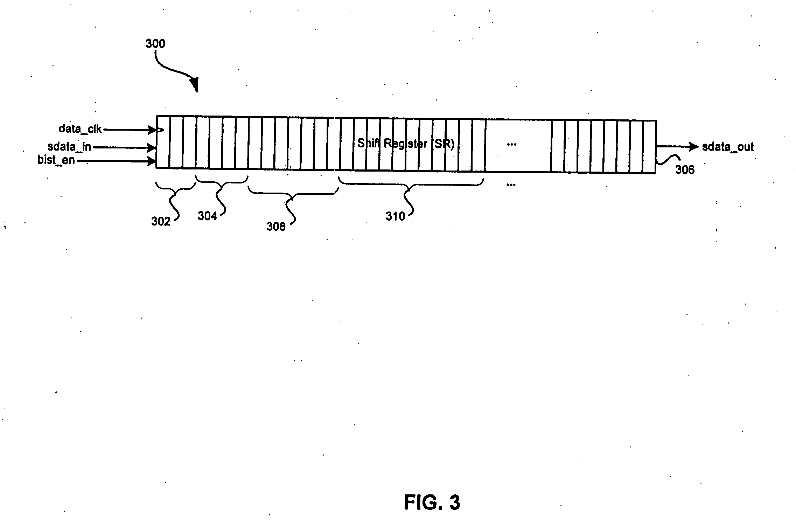

FIG. 3 is a block diagram 300 illustrating an exemplary parameterization for an input to the shift register of the BIST module of FIG. 2 in accordance with an embodiment of the invention. Referring to FIG. 3, the shift register 306 may be arranged so that a first portion 302 of the shift register 306 may contain a command to be executed by the BIST module 202 (FIG. 2). In one embodiment of the invention, the first portion 302 of the shift register 306 may contain a total of 3 bits, thereby providing 2³ or eight (8) possible commands that may be decoded by the decoder 208 (FIG. 2) and provided to the BIST logic block 216 for processing. A second portion 304 of the shift register 306 immediately successive to the first portion 302 may contain a counter value that may be utilized by the counter 210 (FIG. 2). The second portion 304 of the shift register 306 may contain a total of 4 bits, thereby providing 2⁴ or sixteen (16) possible count values that may be utilized by the counter 210.

A third portion 308 of the shift register 306 immediately successive to the second portion 304 may contain a first address value that may be decoded by decoder 208 and provided to the BIST logic block 216 for processing. The third portion 308 of the shift register 306 may contain a total of m bits, thereby providing the possibility of addressing 2^{m} memory locations of the memory 204. A fourth portion 310 of the shift register 306 immediately successive to the third portion 308 may contain a first data value that may be decoded by decoder 208 and provided to the BIST logic block 216 for processing. The fourth portion 310 of the shift register 306 may contain a total of n bits, thereby providing the possibility of writing or reading a 2ⁿ-bits wide word to a location of the memory 204.

The bit size of the command, counter, first address and second address are for illustrative purposes and the invention is not limited in this regard. Additionally, the exact positioning of the command, counter, first address and second address may be altered without departing from the spirit of the invention. In this regard, the command could be followed by the first data, followed by the counter, which may be followed by the first address. Furthermore, there may be more than one address fields, for example a second address, a third address, a fourth address and so on. Similarly, there may be more than one data fields, for example a second data, a third data, a fourth data and so on.

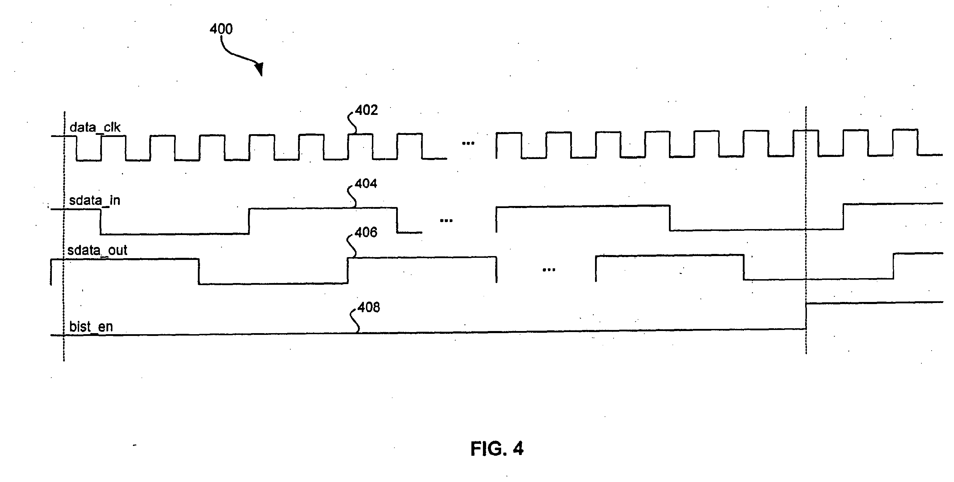

FIG. 4 is an exemplary timing diagram 400 that may be utilized to shift data in and out of the shift register 206 of the BIST module 202 of FIG. 2 in accordance with an embodiment of the invention. Referring to FIG. 4, there is shown clock signals for a data clock (data_clk) signal 402, a data input signal (sdata_in) 404, a data output signal (sdata_out) 406 and a BIST enable signal (bist_en) 408. In accordance with one embodiment of the invention, the shift register may be active whenever the bist_en signal 408 is low. Accordingly, data may be shifted in and out of the shift register 206 whenever the bist_en signal 408 is low. Whenever the bist_en signal 408 is high, data shifting may be suspended and the BIST logic block 216 may become active. In this regard, whenever the bist_en signal 408 is high, memory testing by the BIST module 202 may proceed. The BIST module 202 may be configured to operate at the same frequency as the system clock (clk). Advantageously, this may permit the BIST to test a memory under test at operational speeds. In one aspect of the invention, the clk and data_clk signals may be adapted to be independent signals and in this regard, the clk and data_clk signals may not require synchronization.

Generally, in operation, the BIST module 202 may be controlled by a test software application that may be configured to run, for example on a host system such as a PC. Under control of the test software application, data may be shifted into the shift register 206 with the sdata_in signal and shifted out of the shift register 206 with the sdata_out signal. The speed at which data may be shifted in and shifted out of the shift register 206 may be controlled by the test application software application, through for example, the data_clk signal. The data shifted out of the shift register may contain results of any testing done on a DUT by the BIST module 202.

In one aspect of the invention, the host application software may be adapted so that the bist_en signal may be an active low signal. However, the invention is not limited in this regard. In this case, while the bist_en remains at a logic zero (0) or low, data may be shifted into the shift register 206 via the sdata_in signal. Upon completion of shifting data into the shift register 206, the bist_en signal may be changed to a logic one (1) or high. When this happens, the BIST logic block 216 may subsequently be activated and testing may begin.

In another aspect of the invention, whenever the done signal is a logic one (1) or high, the bist_en signal may be transitioned to a logic zero (0) or low in order to initiate the completion a full test cycle. Upon completion of the actual testing, data which may include test results stored during testing, may be shifted out of the shift register 206 at a rate of data_clk. The data may include information such as an address of a memory location where and error occurred, the expected data (expected_data), the RAM data (rdata_o), the location of the failing columns (col_fail), whether the test was a success or a failure (pass/fail) and information such as fuse repair information. Simultaneously, the host software application may shift new data into the shift register 206 in order to initiate a subsequent test cycle. A done signal generated by the BIST logic block 216 may be set to a logic one (1) or high to represent the completion of testing of a DUT such as a memory module. The first synchronizer 212 may receive the done signal and synchronize the done signal with the data clock signal (data_clk) to generate a done_sync signal. The done_sync signal may be utilized to initiate or signify the beginning of testing of a subsequent memory module or signify the end of testing of a memory as appropriate.

The BIST module 202 may be adapted to include at least two modes of operation, namely, a normal mode and a stop-on-error mode. In accordance with one aspect of the invention, in the stop-on-error mode, the BIST module 202 may be adapted to stop testing on the occurrence of a first error, or a predefined amount of errors. In the stop-on-error mode, whenever the BIST module 202 may be configured to report error data belonging to at least a first memory location of memory module 202 where an error occurred. In this regard, the stop-on-error mode may be notably suitable for a debugging operation rather than a pass/fail analysis. The stop-on-error mode may be controlled by the stop_on_error signal (FIG. 2).

In the normal mode of operation, the BIST module 202 may be adapted to continue testing the at least a portion of the memory module despite the occurrence of one or more errors or failures. An output signal, for example a pass/fail signal, from the comparator 220 may be configured to set a bit in the internal register 218, which may subsequently be read by the host application software. In one embodiment of the invention, the pass fail bit in the internal register 218 may be set to a logic one (1) or high to indicate that the memory module under test is un-repairable.

In accordance with an embodiment of the invention, a unique command set for the BIST module 202 may be provided for executing certain tests, for example, on a DUT such as an embedded single-port or dual-port memory. The flexibility of the software programmable command set may permit testing to be done at operational speed or at speeds slower than operational speed. The unique command set provided for the BIST module 202 may be used to run a battery of tests internal to the DUT and may report information such as simple pass/fail information, detailed test results of a particular memory location that failed a particular test and fuse repair data. In this regard, the unique command set of the BIST module 202 may permit the BIST module 202 to be utilized in a production test environment as well as in a development and/or integration test environment as a debugging or verification tool.

Commands in the command set may be shifted into the shift register 206 under the control of one or more input signals to the shift register 206, for example data_clk, sdata_in, bist_en, and done_sync signals. The commands may be generated by the host application software, which may also control the shifting of data into and out of the shift register. Results data from any testing may be shifted into and out of the shift register where it may be received and analyzed by a host application software.

In accordance with the invention, the shift register 206 along with the BIST module's other associated circuitry may be parameterized, thereby providing a flexible platform or structure for programming commands into the BIST module 202. The commands may be implemented as modular structures that may be adapted to share the rest of the circuitry of the BIST module 202. For example, decoder 208 may be adapted to decode a command portion of the shift register 206 and the counter 210 may be adapted to process a counter portion of the shift register 206. Advantageously, implementation of the commands as a modular structure may easily facilitate the addition of new commands to an existing command set. In this regard, the addition of a new command to the command set may not require the removal of any existing command prior to fabrication.

The shift register 206 may be parameterized depending on factors such as the size and architecture of the embedded DUT. In accordance with one aspect of the invention, parameters such as an address width (addr_width), RAM width (ram_width), RAM size (ram_size), memory blocks (mblocks) and redundant rows per block (rpairs) may be used to facilitate parameterization of the shift register 206. The addr_width parameter may represent a number of bits of the binary address information that may be used to identify a particular memory location. The ram_width parameter may represent a number of bits of the binary data information. The ram_size parameter may represent a size of the DUT or memory. The mblocks parameter may represent a number of blocks in the DUT or memory. The rpairs parameter may represent a number of redundant rows per memory block in the DUT or memory.

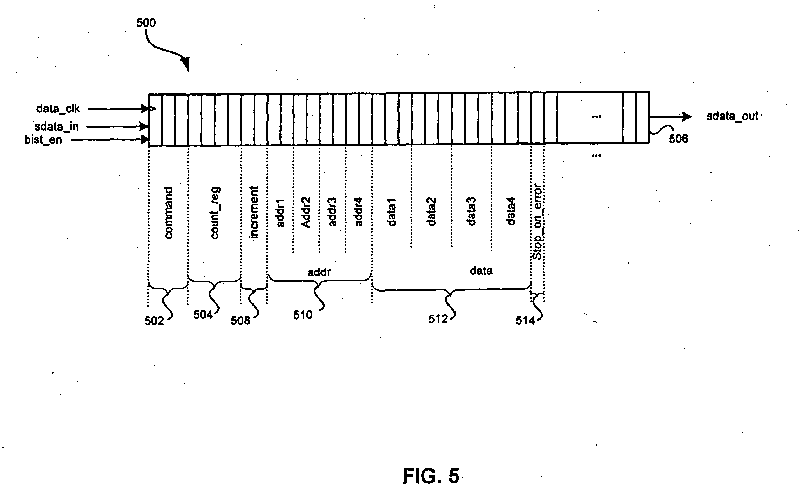

The contents of the shift register 206 may be parameterized differently depending on whether data in the shift register is an input to the BIST module 202 or an output from the BIST module 202. FIG. 5 is a block diagram illustrating an exemplary parameterization for an input command for the shift register 506 in accordance with an embodiment of the invention. Referring to FIG. 5, the shift register 506 may be parameterized to include a command portion 502, a count_reg portion 504, a count increment portion 508, an address portion 510, a data portion 512 and a stop_on_error portion 514. The address portion 510 may be further parameterized into, for example, four address portions, namely addr1, addr2, addr3, and addr4. The data portion 512 may be further parameterized into, for example, four data portions, namely data1, data2, data3, and data4.

In accordance with an embodiment of the invention, input bits to the shift register 506 may be allocated as follows.

| Register Bit Position(s) (Start to Stop) | Register Portion | No. Of Bits |
|---|---|---|
| 0 to 2 | command | 3 |
| 3 to 6 | Counter_reg | 4 |
| 7 to addr_width+5 | increment | addr_width -1 |
| addr_width+6 to (2*addr_width)+5 | addr1 | addr_width |
| (2*addr_width)+6 to (3*addr_width)+5 | addr2 | addr_width |
| (3*addr_width)+6 to (4*addr_width)+5 | addr3 | addr_width |
| (4*addr_width)+6 to (5*addr_width)+5 | addr4 | addr_width |
| (5*addr_width)+6) to am_width+(5*addr_width)+5 | data1 | ram_width |
| ram_width+(5*addr_width)+6) to 2*ram_width)+(5*addr_width)+5 | data2 | ram_width |
| (2* ram_width)+(5*addr_width)+6) to (3*ram_width)+(5*addr_width)+5 | data3 | ram_width |
| (3* ram_width)+(5*addr_width)+6 to (4*ram_width)+(5*addr_width)+5 | data4 | ram_width |
| (4*ram_width)+(5*addr_width)+6 | stop_on_error | 1 |

In this regard, the total number of bits or size of the shift register 506 may be equivalent to (4*ram_width + 5*addr_width + 7). However, it should readily be recognized that the invention is not limited to this exact parameterization arrangement of bit allocation, and other arrangements of bit allocation may be possible without departing from the true scope of the invention.

The command portion 502 of the shift register 506 may contain 3 bits, thereby providing 2³ or eight (8) possible commands that may be decoded by the decoder 208 (FIG. 2) and provided to the BIST logic block 216 for processing. The command portion 502 may determine which command the BIST module 202 will execute. The count_reg portion 504 may contain a counter value that may be utilized by the counter 210 (FIG. 2) to determine the frequency with which a command should be executed. The count_reg portion 504 may contain a total of 4 bits, thereby providing 2⁴ or sixteen (16) possible count values that may be utilized by the counter 210. The counter increment portion 506 may contain a counter increment value that may be utilized by the counter 210 (FIG. 2). The counter increment portion 506 may contain a plurality of bits that may define how the counter gets incremented. For example, if the address width addr_width is 8, then the counter increment portion 506 contains 7 bits, the counter 210 may be instructed to increment in one of 2⁷ or one hundred and twenty eight (128) possible increments. In one aspect of the invention, an address pointer may be adapted to control incrementing operations of the counter 210. In this regard, if the increment value is one, the address pointer may be incremented or decremented by one.

Each of addr1, addr2, addr3 and addr4 in the address portion 510 of the shift register 506 may have a width defined by addr_width. Accordingly, the total number of bits occupied by the address portion 510 may be four (4) times the addr_width. The address width may be programmable by the host software application. Although addr1, addr2, addr3 and addr4 may be physical memory locations address, addr1, addr2, addr3 and addr4 may utilize any memory-mapping scheme to identify a particular memory location. In this regard, addr1, addr2, addr3 and addr4 may be, for example, an offset or a pointer to a memory location. The address width may be programmable by the host software application.

Each of data1, data2, data3, and data4 in the data portion 512 of the shift register 506 may have a width defined by a width of the DUT or RAM, namely ram_width. Accordingly, the total number of bits occupied by the address portion 510 may be four (4) times the addr_width. The ram_width and data portions of data portion 512 may be programmable by the host software application. The stop-on-error portion 514 may be adapted to include a single bit.

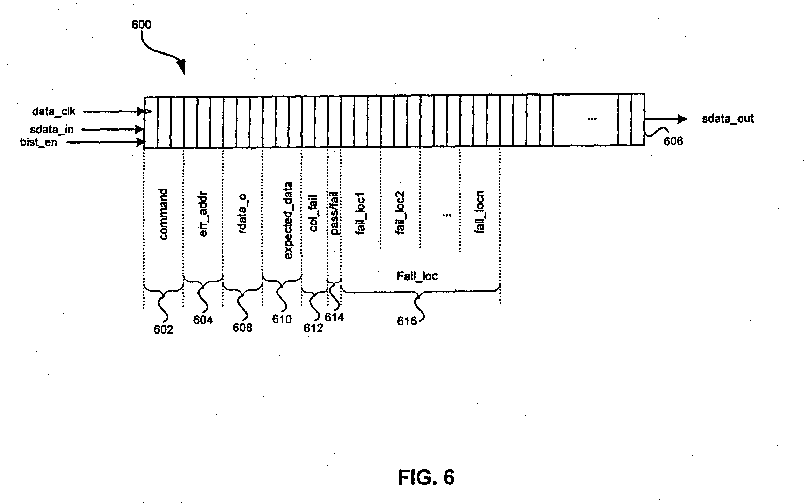

FIG. 6 is a block diagram illustrating an exemplary parameterization for output data for the shift register 606 in accordance with an embodiment of the invention. Referring to FIG. 6, the shift register 606 may be parameterized to include a command portion 602, a err_addr portion 604, an rdata_o portion 608, an expected_data portion 610, a col_fail portion 612, a pass/fail portion 614, and a fail_loc portion 616. The fail_loc portion 616 may be further parameterized to include one or more fail_loc portions, namely fail_loc1, fail_loc2, ..., fail_locn. In this regard, there may be n fail_loc portions, where n may represents the number of block in the RAM or DUT.

The command portion 602 may represent the command that was executed by the BIST module 202. The err_add portion 604 may represent the last address location where a failure occurred. The rdata_o portion 608 may represent the data information found at the failing address location. The expected_data portion 610 may represent the data information that was expected from the failing address location. The col_fail portion 612 may represent an accumulated result of the failing columns of a RAM module or DUT. The pass_fail 614 bit may represent whether the DUT failed or passed a particular test. The fail_loc portion 616 may represent row information for any repairable failing locations found in each block. This information may subsequently be used to repair a row repair after testing is done.

In accordance with an embodiment of the invention, output bits from the shift register 606 may be allocated as follows.

| Register Bit Position(s) (Start to Stop) | Register Portion | No. Of Bits |
|---|---|---|
| 0 to 2 | command | 3 |
| 3 to addr_width+2 | err_addr | addr_width |
| addr_width+3 to ram_width+addr_width+2 | rdata_o | ram_width |
| ram_width+addr_width+3) to (2*ram_width)+addr_width+2 | expected_data | ram_width |
| (2*ram_width)+addr_width+3) to ((3*ram_width)+ addr_width+2 | col_fail | ram_width |
| ((3*ram_width)+ addr_width+3) | pass_fail | 1 register |
| (3*ram_width)+ addr_width+4) to rpairs+1+(3*ram_width)+ addr_width+3 to | fail_loc1 | rpairs+1 |
| rpairs+1+(3*ram_width)+ addr_width+4)) to (2*(rpairs+1 )+(3*ram_width)+ addr_width+3 | fail_loc2 | size: rpairs+1 |
| 2*(rpairs+1 )+(3*ram_width)+ addr_width+4)) to (3*(rpairs+1)+(3*ram_width)+ addr_width+3 | fail_loc3 | rpairs+1 |
| 3*(rpairs+1)+(3*ram_width)+ addr_width+4)) to (4*(rpairs+1)+(3*ram_width)+ addr_width+3 | fail_loc4 | rpairs+1 |
| 4*(rpairs+1)+(3*ram_width)+ addr_width+4)) to (5*(rpairs+1)+(3*ram_width)+ addr_width+3 | fail_loc5 | rpairs+1 |
| 5*(rpairs+1)+(3*ram_width)+ addr_width+4)) fail_loc6 to (6*(rpairs+1)+(3*ram_)width)+ addr_width+3 | | rpairs+1 |

In this regard, ((4*ram_width)+(5*addr_width)+6 : (8(or4) * (rpairs+1 ) + (3*ram_width) + addr_width+3)) may be set to zero (0). It should readily be recognized that the invention is not limited to this exact arrangement of bit allocation for the output of the shift register 606, and other bit allocation arrangements for the output of the shift register 606 may be possible without departing from the true scope of the invention.

In accordance with an embodiment of the invention, the first three bits of the shift register may contain a command to be executed by the BIST module 202. Exemplary commands and their binary representation may be as follows, although the invention is not limited in this regard.

| Binary | Description |
|---|---|
| 001 | Read the contents of a single memory location |
| 010 | Write to one or more memory locations |
| 011 | Write to four addresses specified in the shift register followed by read from the same four addresses |
| 100 | Write from address1 to address2 sequentially, data1, data2, data3 and data4 as specified in the shift register followed by a read from address1 to address2. |
| 110 | Write data1 to the whole memory starting from the first address incrementing up to the last address. Once the last address location is written, a read and consecutive write of data2 starts from the last memory location back to the first address location. |
| 000 | Write address information to the address location, then walking 1's and walking 0's. This test may use a hard coded test pattern. |
| 101 | No operation (NOP). Although the BIST is active, it releases control of the memory to the chip. |
| 111 | Sleep. While the BIST is active, it disables memory access from the chip. |

These commands 000, 011, 100, 101, 110, 111 listed above may be utilized with the exemplary parameterization of FIG. 5 and FIG. 6. Subsequent to the execution of any one of the above commands, the results may be stored in the shift register by overwriting any existing contents of the shift register. Accordingly, the contents of the shift register representing results of the testing may be shifted out to be processed by, for example, a host application software. Any unused bits in the shift register may be set to zero.

The contents of the shift register after execution of the command 001 may be parameterized as follows.

| Register Bit Position(s) (Start to Stop) | Register Portion | No. Of Bits |
|---|---|---|
| 0 to 2 | 001 | 3 |
| 3 to addr_width+3 to ram_width+addr_width+2 | rdata_o | ram_width |
| ram_width+addr_width+3) to (2*ram_width)+addr_width+2 | expected_data | ram_width |

Bits (4*ram_width)+(5*addr_width)+6 through (ram_width +3) may be set to zero. The read command 001 may be used after a 010 command or another command that utilizes a write (W) operation.

The contents of the shift register after execution of the command 010 may be parameterized as follows.

| **Register Bit Position(s) (Start to Stop)** | **Register Portion** | **No. Of Bits** |
|---|---|---|
| 0 to 2 | 010 | 3 |

Bits three (3) through (4*ram_width)+(5*addr_width)+6 may be set to zero.

In one embodiment of the invention, the BIST logic block 216 may be adapted to compare the contents (rdata_o) of each memory address with expected data (expected_data) by performing and exclusive OR (XOR) operation on corresponding bits of the rdata_o signal and the expected_data signal. In this case, if the results of the XOR operation are all zero (0) bits, the rdata_o is same as expected_data and no errors are present. Accordingly, a pass condition may be declared by a pass/fail bit in the pass/fail portion 614. However, if any of the XOR operation results in data bits being equivalent to a logic one (1), an error condition may be indicated or declared for the particular location. In this case, an address for the failing memory location may be stored as and error address in the fail_loc section 616, particularly in one of the locations fail_loc1, fail_loc2, ..., fail_locn. At the end of the test, the last error address and other corresponding related data values such as expected_data and rdata_o may be loaded into the shift register 606 and subsequently shifted out.

In accordance with one aspect of the invention, the read (R) command 001 may utilize the following input syntax: R(addr1, counter_reg). This may permit the BIST module 202 to read the contents of the memory location specified by addr1. The read operation may be performed repeatedly depending on a value specified by counter_reg. If counter_reg is four bits, the minimum and maximum number of times that the specified address may be read is one (1) and fifteen (15) respectively.

The write command (W) 010 may utilize the following input syntax: W(addr1, data1, counter_reg). This may permit the BIST module 202 to write data1 to the memory location specified by addr1. The write operation (W) may be performed repeatedly depending on a value specified by counter_reg.

The 011 command may utilize the following input syntax: WR(addr1, addr2, addr3, addr4, data1, data2, data3, data4, counter_reg). This may permit the BIST module 202 to write data1 to addr1, data2 to addr2, data3 to addr3 and data4 to addr4, then reads data1 from addr1, data2 from addr2, data3 from addr3, and data4 from addr4. The write operation (W) may be performed repeatedly depending on a value specified by counter_reg. If the counter_reg value is zero, the command may be executed once, although the invention is not so limited.

The command 100 may utilize the following input syntax: WR(addr1, addr2, data1, data2, data3, data4, increment, counter_reg). This may permit the BIST module to write data1, data2, data3, data4 to memory starting from a memory address specified by addr1 and ending at the memory address specified by addr2, with the step value specified by increment. The contents of the memory may subsequently be read starting from the memory address specified by address addr1 and ending at the memory address specified by addr2, using the with the same step value specified by increment. In general, the increment may be greater than zero (0) and the step may be equivalent to increment plus one (1). In accordance with one aspect of the invention, the difference between addr1 and addr2 may be a factor of four (4). The minimum step size may be one (1) and the maximum step size may be equivalent to (ram_size-1 )/2. If the counter_reg value is zero, the command may be executed once, although the invention is not so limited.

In accordance with one aspect of the invention, the BIST module 202 may perform marching test using command 110. The syntax for command 110 may be as follows: data1, data2, data3, data4, increment, counter_reg. In general, the increment may be greater than zero (0) and the step may be equivalent to increment plus one (1). In accordance with one aspect of the invention, the minimum step size may be one (1) and the maximum step size may be equivalent to (ram_size-1)/2. If the counter_reg value is zero, the command may be executed once, although the invention is not so limited.

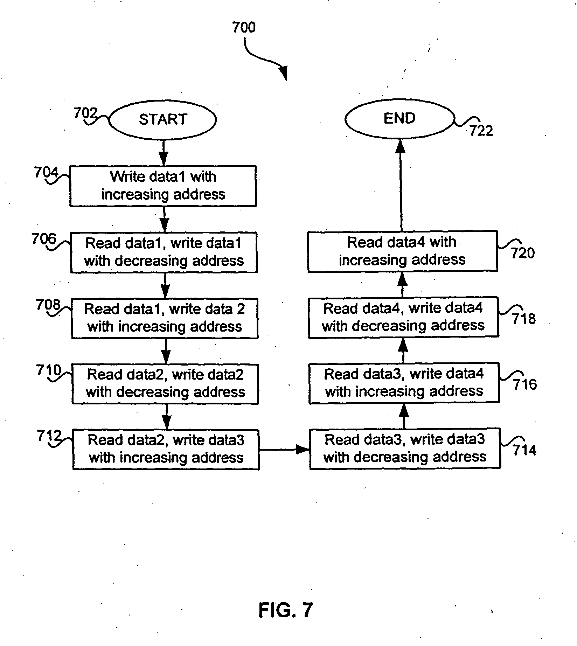

FIG. 7 is a flow chart 700 illustrating an exemplary marching test using command 110 in accordance with an embodiment of the invention. Referring to FIG. 7, the exemplary steps may start at step 702. In step 704, data1 may be written to the complete memory with an increasing address, starting for example, at the first memory location. In step 706, data1 which was written in step 704 may be read from the complete memory with a decreasing address and data 1 may be written with a decreasing address to the complete memory. In step 708, data1 which was written in step 706 may be read and data2 may be written with an increasing address to the complete memory. In step 710, data2 which was written in step 708 may be read and data2 may be written with a decreasing address to the complete memory. In step 712, data2 which was written in step 710 may be read and data3 may be written with an increasing address to the complete memory.

In step 714, data3 which was written in step 712 may be read and data3 may be written with a decreasing address to the complete memory. In step 716, data3 which was written in step 714 may be read and data4 may be written with an increasing address to the complete memory. In step 718, data4 which was written in step 716 may be read and data4 may be written with a decreasing address to the complete memory. In step 720, data4 which was written in step 718 may be read with increasing address. The steps may end at step 722. Although not shown, corresponding data for each read and write operation may be compared by comparator 220 (FIG. 2) and the results recorded in the internal register 218 and/or loaded into the shift register 206. The comparator 220 may utilize, for example, an XOR operation on the RAM data (rdata_o) and the expected data (expected_data) to determine its validity.

In accordance with another aspect of the invention, the BIST module 202 may perform marching test using command 000. The syntax for command 000 may be as follows: increment, counter_reg. In general, the increment may be greater than zero (0) and the step may be equivalent to increment plus one (1). In accordance with one aspect of the invention, the minimum step size may be one (1) and the maximum step size may be equivalent to (ram_size/ram_width). The maximum step may be divisible by the step value. If the counter_reg value is zero, the command may be executed once, although the invention is not so limited.

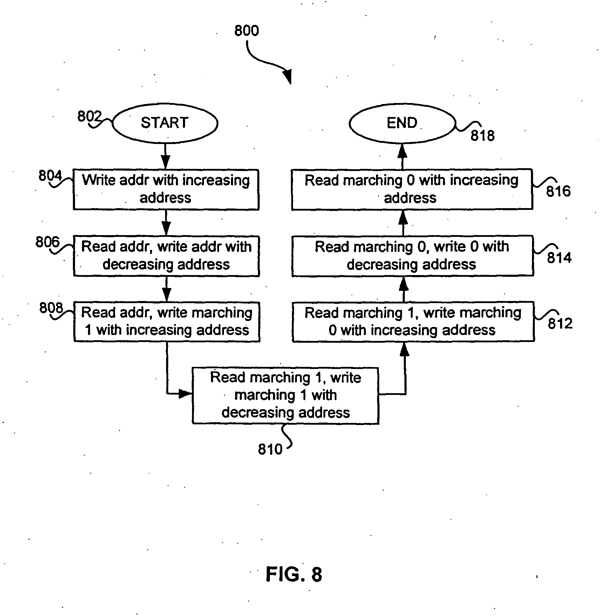

FIG. 8 is a flow chart 800 illustrating an exemplary marching test using command 000 in accordance with an embodiment of the invention. Referring to FIG. 8, the exemplary steps may start at step 802. In step 804, the address of a particular memory location may be written to that particular memory location with an increasing address, starting for example, at a first memory location, and repeatedly done for each memory location for the complete memory. In step 806, the addresses for each of the memory locations, which were written in step 804 may be read and the address of a particular memory location may be written to that particular memory location with a decreasing address, starting for example, at a last memory location.

In step 808, the addresses for each of the memory locations, which were written in step 806 may be read and a marching ones (1's) pattern written to the complete memory with an increasing address. In step 810, the marching ones (1's) pattern which was written in step 808 may be read and a marching ones (1's) pattern written to the complete memory with a decreasing address. In step 812, the marching ones (1's) pattern which was written in step 810 may be read and a marching zeros (0's) pattern written to the complete memory with an increasing address. In step 814, the marching ones (1's) pattern which was written in step 812 may be read and a marching zeros (0's) pattern written to the complete memory with a decreasing address. In step 816, the marching zeros (0's) pattern which was written in step 814 may be read with an increasing address. The steps may end at step 818.

The following is an exemplary marching zeros (0's) pattern in accordance with an embodiment of the invention.

| Memory Location | Pattern |
|---|---|
| Addr1 | 1111111110 |
| Addr2 | 1111111101 |
| Addr3 | 1111111011 |
| Addr3 | 1111110111 |
| Addr5 | 1111101111 |
| Addr6 | 1111011111 |
| Addr7 | 1110111111 |
| Addr8 | 1101111110 |
| Addr9 | 1011111110 |
| Addr10 | 0111111110 |

The following is an exemplary marching zeros (0's) pattern in accordance with an embodiment of the invention.

| Memory Location | Pattern |
|---|---|
| Addr1 | 0000000001 |
| Addr2 | 0000000010 |
| Addr3 | 0000000100 |
| Addr3 | 0000001000 |
| Addr5 | 0000010000 |

| Memory Location | Pattern |
|---|---|
| Addr6 | 0000100000 |
| Addr7 | 0001000000 |
| Addr8 | 0010000000 |
| Addr9 | 0100000000 |
| Addr10 | 1000000000 |

An address pointer or an index may be utilized to navigate the increasing and decreasing address. Although not shown, corresponding data for each read and write operation may be compared by comparator (FIG. 220) and the results recorded in the internal register 218 and/or loaded into the shift register 206. The comparator 220 may utilize, for example, an XOR operation on the RAM data (rdata_o) and the expected data (expected_data) to determine its validity.

A no operation (NOP) command 101 may be provided in accordance with an embodiment of the invention. Whenever the BIST module 202 is active, the NOP command may be used to enable access to a DUT or RAM module. Command 101 may permit a debug mode of operation by BIST module 202. In this regard, read/write (W/R) operations to memory or DUT by devices other than the BIST module 202 may occur concurrently with the loading of test results into the shift register 206 and the shifting of the loaded test results out of the shift register out. Notably, the BIST does no testing during once a NOP mode of operation is initiated.

A sleep command 111 may also be provided in accordance with an embodiment of the invention. Whenever the BIST module 202 is active, the sleep command may be adapted to disable a DUT, for example by keeping the chip_en at logic zero (0) or low so that the chip cannot access the DUT. In this regard, the sleep command may prevent access to a memory module by the chip or other device.

While the invention has been described with reference to certain embodiments, it will be understood by those skilled in the art that various changes may be made and equivalents may be substituted without departing from the scope of the invention. In addition, many modifications may be made to adapt a particular situation or material to the teachings of the invention without departing from its scope. Therefore, it is intended that the invention not be limited to the particular embodiment disclosed, but that the invention will include all embodiments falling within the scope of the appended claims.

Accordingly, the present invention may be realized in hardware, software, or a combination of hardware and software. The present invention may be realized in a centralized fashion in one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention also may be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

Notwithstanding, the invention and its inventive arrangements disclosed herein may be embodied in other forms without departing from the spirit or essential attributes thereof. Accordingly, reference should be made to the following claims, rather than to the foregoing specification, as indicating the scope of the invention. In this regard, the description above is intended by way of example only and is not intended to limit the present invention in any way, except as set forth in the following claims.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

## Claims

1. A method for programming a software verification tool for testing and debugging an embedded device under test, the method comprising:
generating an instruction for causing at least one predetermined test to be executed by a BIST module on the embedded device under test;
loading said generated instruction into a parameterized shift register of said BIST module;
determining an identity of said at least one predetermined test based on said loaded instruction; and
generating at least one signal corresponding to said determined identity of said at least one predetermined test for causing control and execution of the testing and debugging of the device under test.

2. The method according to claim 1, wherein said generating further comprises assembling at least one command into said generated instruction within a host application software.

3. The method according to claim 2, wherein said loading further comprises generating at least one clock signal from said host application software, said at least one clock signal controlling said loading of said instruction into said parameterized shift register.

4. The method according to claim 3, wherein said loading further comprises shifting said instruction into said parameterized shift register.

5. A system for programming a software verification tool for testing and debugging an embedded device under test, the system comprising:
at least one generator adapted to generate an instruction for causing at least one predetermined test to be executed by a BIST module on the embedded device under test;
at least one loader adapted to load said generated instruction into a parameterized shift register of said BIST module;
an identifier adapted to determining an identity of said at least one predetermined test based on said loaded instruction; and
said at least one generator adapted to generate at least one signal corresponding to said determined identity of said at least one predetermined test for causing control and execution of the testing and debugging of the device under test.

6. The system according to claim 5, wherein said at least one generator further comprises an assembler adapted to assemble at least one command into said generated instruction within a host application software.

7. A command set for programming a software verification tool for testing and debugging an embedded device under test, the command set comprising:
at least one instruction generated for causing at least one predetermined test to be executed by a BIST module on the embedded device under test;
said at least one generated instruction parameterized and shifted into a parameterized shift register of said BIST module;
said at least one instruction comprising an identity of said at least one predetermined test based on said loaded instruction; and
said at least one instruction for causing the generation of at least one signal corresponding to said identity of said at least one predetermined test for causing control and execution of the testing and debugging of the device under test.

8. The command set according to claim 7, wherein said at least one instruction further comprises at least one command contained within a command portion of said at least one instruction said command assembled into said command portion by a host application software.

9. A machine-readable storage, having stored thereon a computer program having at least one code section for implementing a command set for programming a software verification tool for testing and debugging an embedded device under test, the code sections executable by a machine for causing the machine to perform the steps comprising:
generating an instruction for causing at least one predetermined test to be executed by a BIST module on the embedded device under test;
loading said generated instruction into a parameterized shift register of said BIST module;
determining an identity of said at least one predetermined test based on said loaded instruction; and
generating at least one signal corresponding to said determined identity of said at least one predetermined test for causing control and execution of the testing and debugging of the device under test.

10. The machine-readable storage according to claim 9, wherein said generating code section further comprises at least one code section for assembling at least one command into said generated instruction within a host application software.
